# EUROPEAN PATENT APPLICATION

(11) **EP 4 811 422 A1**
(43) Date of publication of application: **23.09.2026**
(21) Application number: 24926625.5
(22) Date of filing: 18.07.2024
(51) Int. Cl.: H01L 21/60, H02P 29/60, H01L 25/16, H01L 23/34, H01L 23/498

(54) **POWER MODULE AND MANUFACTURING METHOD THEREFOR**

(30) Priority: 29.02.2024 CN 202410224095
(71) Applicant: Zinsight Technology (Shanghai) Co. Ltd, Shanghai 201114 (CN)
(72) Inventor: ZHU, Nan, Shanghai 201114 (CN); XU, He, Shanghai 201114 (CN); WEI, Xuejun, Shanghai 201114 (CN); CHEN, Zhirong, Shanghai 201114 (CN)
(74) Representative: HGF
(86) International application number: PCT/CN2024/106118
(87) International publication number: WO 2025/179756

(57) **Abstract**

The present disclosure provides a power module and a manufacturing method thereof. The power module is configured to drive electric motors and electric heaters, and includes an electric motor control section and an electric heater control section. A plurality of power chips of the electric motor control section and a plurality of power chips of the electric heater control section are integrated in the power module.

## Description

### RELATED APPLICATIONS

This disclosure claims priority to Chinese Patent Application No. 202410224095.9, filed on February 29, 2024, entitled "Power Module Integrating Motor and Electric Heater Drives and Manufacturing Method Therefor", the entire content of which is incorporated herein by reference.

### TECHNICAL FIELD

The present disclosure relates to the field of power electronics technology, and in particular, to a power module integrating electric motor and electric heater drives and a manufacturing method therefor.

### BACKGROUND

Currently, in two-in-one controllers of automotive electric compressors and electric heaters, multiple discrete IGBTs need to be used in combination, and these multiple discrete IGBTs are installed separately inside the controller. Multiple discrete IGBTs occupy a large amount of space, which is not conducive to the miniaturization of the product. Discrete IGBTs require the use of thermally conductive insulating cloth or ceramic sheets to achieve insulation and thermal conductivity. However, the thermal conductivity of thermally conductive insulating cloth is low, which is not conducive to heat dissipation, and ceramic sheets are fragile, making assembly difficult. In addition, discrete IGBTs use external temperature sensors to detect their temperature. Affected by ambient temperature and thermal resistance, external temperature sensors cannot accurately detect the temperature of IGBTs, which makes IGBTs prone to overheating and failure.

### SUMMARY

In view of this, the present disclosure provides a power module and a manufacturing method therefor.

In a first aspect, a power module is provided, which includes:
an electric motor control section, including a plurality of power chips for driving an electric motor; and
an electric heater control section, including a plurality of power chips for driving an electric heater.

The plurality of power chips of the electric motor control section and the plurality of power chips of the electric heater control section are integrated in the power module.

Optionally, the power chips of the electric motor control section include at least one of an IGBT chip, a SiC chip, a MOSFET chip, and a GaN chip.

Optionally, the plurality of power chips of the electric heater control section include at least one of an IGBT chip, a SiC chip, a MOSFET chip, and a GaN chip.

Optionally, the plurality of power chips of the electric motor control section include a first chip unit, a second chip unit, a third chip unit, a fourth chip unit, a fifth chip unit, and a sixth chip unit.

Optionally, each of the first chip unit, the second chip unit, the third chip unit, the fourth chip unit, the fifth chip unit, and the sixth chip unit includes an IGBT chip.

Optionally, the plurality of power chips of the electric heater control section include a seventh chip unit, an eighth chip unit, and a ninth chip unit.

Optionally, seventh chip unit, the eighth chip unit, and the ninth chip unit are all IGBT chips.

Optionally, each of the power chips includes a first port, a second port, and a third port, the first port is a gate, the second port is a collector, and the third port is an emitter.

Optionally, the first port of the first chip unit is connected to a first pin of the power module;
the second port of the first chip unit is connected to the second port of the second chip unit, the second port of the third chip unit, the second port of the seventh chip unit, and an eighteenth pin of the power module;
the third port of the first chip unit is connected to a second pin of the power module, the second port of the fourth chip unit, and a nineteenth pin of the power module;
the first port of the second chip unit is connected to a third pin of the power module;
the third port of the second chip unit is connected to a fourth pin of the power module, the second port of the fifth chip unit, and a twentieth pin of the power module;
the first port of the third chip unit is connected to a fifth pin of the power module;
the third port of the third chip unit is connected to a sixth pin of the power module, the second port of the sixth chip unit, and a twenty-first pin of the power module;
the first port of the fourth chip unit is connected to a seventh pin of the power module;
the third port of the fourth chip unit is connected to an eighth pin of the power module and a twenty-second pin of the power module;
the first port of the fifth chip unit is connected to a ninth pin of the power module;
the third port of the fifth chip unit is connected to a tenth pin of the power module and a twenty-third pin of the power module;
the first port of the sixth chip unit is connected to an eleventh pin of the power module; and
the third port of the sixth chip unit is connected to a twelfth pin of the power module and a twenty-fourth pin of the power module.

Optionally, the first pin is a GUH pin, the second pin is a KUN pin, the third pin is a GVH pin, the fourth pin is a KVH pin, the fifth pin is a GWH pin, the sixth pin is a KWH pin, the seventh pin is a GUL pin, the eighth pin is a KUL pin, the ninth pin is a GVL pin, the tenth pin is a KVL pin, the eleventh pin is a GWL pin, the twelfth pin is a KWL pin, the eighteenth pin is a P pin, the nineteenth pin is a U pin, the twentieth pin is a V pin, the twenty-first pin is a W pin, the twenty-second pin is a NU pin, the twenty-third pin is a NV pin, and the twenty-fourth pin is a NW pin.

Optionally, the first port of the seventh chip unit is connected to a thirteenth pin of the power module;
the emitter of the seventh chip unit is connected to a fourteenth pin of the power module and a twenty-fifth pin of the power module;
the first port of the eighth chip unit is connected to a fifteenth pin of the power module;
the second port of the eighth chip unit is connected to a twenty-sixth pin of the power module;
the third port of the eighth chip unit is connected to the third port of the ninth chip unit, a seventeenth pin of the power module and a twenty-eighth pin of the power module;
the first port of the ninth chip unit is connected to a sixteenth pin of the power module; and
the second port of the ninth chip unit is connected to a twenty-seventh pin of the power module.

Optionally, the thirteenth pin is a G1 pin, the fourteenth pin is a K1 pin, the fifteenth pin is a G2 pin, the sixteenth pin is a G3 pin, the seventeenth pin is a K23 pin, the twenty-fifth pin is a E1 pin, the twenty-sixth pin is a C2 pin, the twenty-seventh pin is a C3 pin, and the twenty-eighth pin is a E23 pin.

Optionally, the power module further includes:
a direct bonded copper ceramic substrate, on which the plurality of power chips of the electric motor control section and the plurality of power chips of the electric heater control section are mounted.

Optionally, it further includes:
a plurality of temperature sensors configured to detect temperatures of the plurality of power chips of the electric motor control section and temperatures of the plurality of power chips of the electric heater control section.

Optionally, the plurality of temperature sensors include a first temperature sensor and a second temperature sensor;
one end of the first temperature sensor is connected to a twenty-ninth pin of the power module;
the other end of the first temperature sensor is connected to a thirtieth pin of the power module;
one end of the second temperature sensor is connected to a thirty-first pin of the power module;
the other end of the second temperature sensor is connected to a thirty-second pin of the power module; and
the twenty-ninth pin is a T1-1 pin, the thirtieth pin is a T1-2 pin, the thirty-first pin is a T2-1 pin, and the thirty-second pin is a T2-2 pin.

In a second aspect, a manufacturing method for a power module is provided, including integrating, by a process including reflow soldering and aluminum wire ultrasonic bonding, a plurality of power chips for driving an electric motor and a plurality of power chips for driving an electric heater onto a direct bonded copper ceramic substrate to jointly form the power module.

Optionally, the method includes packaging, by a process including reflow soldering and aluminum wire ultrasonic bonding, a plurality of temperature sensors, the plurality of power chips for driving the electric motor, and the plurality of power chips for driving the electric heater in the power module.

### BRIEF DESCRIPTION OF THE DRAWINGS

To more clearly illustrate the technical solutions of the embodiments of the present disclosure, the accompanying drawings required in the embodiments will be briefly introduced below. Obviously, the drawings described below are only some embodiments of the present disclosure. For those of ordinary skill in the art, other drawings can also be obtained based on these drawings without exerting creative labor.
FIG. 1 is a schematic structural diagram of a power module according to one or more embodiments of the present disclosure.
FIG. 2 is a schematic structural diagram of a power module according to one or more embodiments of the present disclosure.

### DETAILED EMBODIMENTS

The following will clearly and completely describe the technical solutions in the embodiments of the present disclosure in conjunction with the accompanying drawings in the embodiments of the present disclosure. Obviously, the described embodiments are only a part of the embodiments of the present disclosure, not all of them. Based on the embodiments in the present disclosure, all other embodiments obtained by those of ordinary skill in the art without making creative efforts shall fall within the protection scope of the present disclosure.

The embodiments of the present disclosure will be described in detail below with reference to the accompanying drawings.

It should also be noted that the diagrams provided in the following embodiments only illustrate the basic concept of the present disclosure in a schematic way. The diagrams only show the components related to the present disclosure, rather than drawing according to the number, shape and size of the components in actual implementation. In actual implementation, the form, number and proportion of each component can be changed arbitrarily, and the layout form of the components may also be more complex.

In addition, in the following description, details are provided to facilitate a thorough understanding of the examples. However, those skilled in the art will understand that it can be practiced without these specific details.

In-depth research on power modules, as well as power modules for driving electric motors and electric heaters, has found that in related technologies, two-in-one controller product for vehicle-mounted electric compressors and electric heaters require 8 to 10 IGBTs (Insulate-Gate Bipolar Transistor). 6 of them form 3 H-bridges to control the electric motor, and the other 2 to 4 discrete IGBTs control the electric heater. Multiple discrete IGBTs are used in a mixed manner and are installed distributedly in the controller. Discrete IGBTs need to use external temperature sensors to detect IGBT temperature for thermal protection, and use thermally conductive insulating pads to achieve insulation and heat dissipation.

However, in the two-in-one controller for vehicle-mounted electric compressors and electric heaters in related technologies, multiple discrete IGBTs occupy a large amount of space, which is not conducive to the miniaturization of the product. Discrete IGBTs require the use of thermally conductive insulating cloth or ceramic sheets to achieve insulation and thermal conductivity. However, the thermal conductivity of thermally conductive insulating cloth is low, which is not conducive to heat dissipation, and ceramic sheets are fragile, making assembly difficult. In addition, discrete IGBTs use external temperature sensors to detect their temperature. Affected by ambient temperature and thermal resistance, external temperature sensors cannot accurately detect the temperature of IGBTs, which makes IGBTs prone to overheating and failure. Moreover, in the two-in-one controller for vehicle-mounted electric compressors and electric heaters in related technologies, multiple discrete IGBT devices need to be mounted on a heat sink, resulting in low installation efficiency and low heat dissipation efficiency.

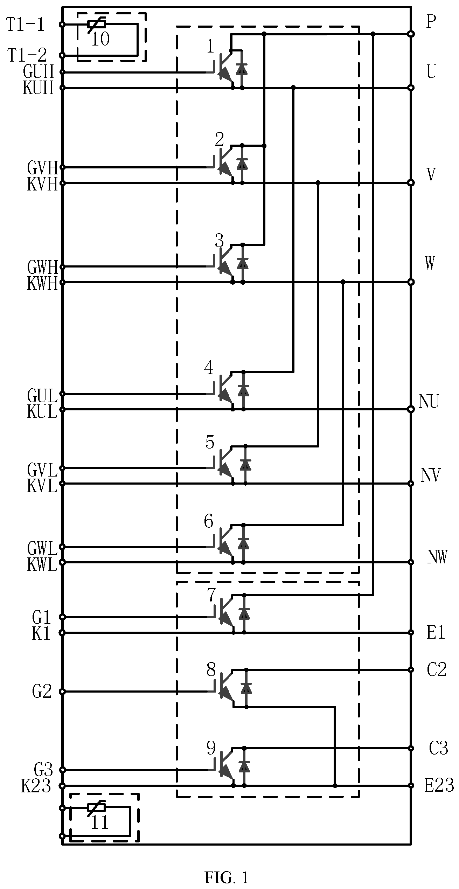

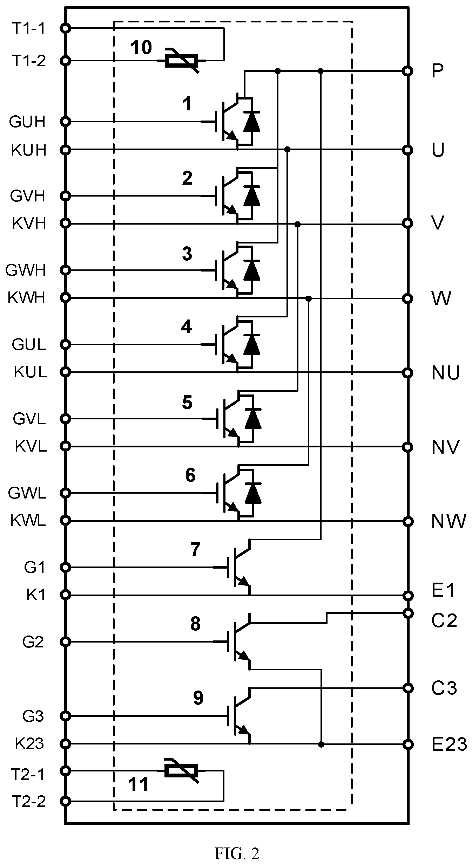

Based on this, the following describes the technical solutions provided by the various embodiments of the present disclosure in conjunction with FIG. 1 and FIG. 2.

The embodiments of this description provide a power module. The power module is configured to drive an electric motor and an electric heater. As shown in FIG. 1, the power module includes an electric motor control section and an electric heater control section. The electric motor control section includes a plurality of power chips for driving the electric motor, and the electric heater control section includes a plurality of power chips for driving the electric heater. The plurality of power chips in the electric motor control section and the plurality of power chips in the electric heater control section are integrated into the power module.

In this embodiment, the power module integrates the power chips for controlling the electric motor and the power chips for controlling the electric heater into a single module. The single power module is configured to realize the functions of controlling both the electric motor and the electric heater, which is beneficial to reducing the volume of the power module, thereby reducing the volume of the integrated controller for the electric compressor and the electric heater, and simplifying the production process of the integrated controller for the electric compressor and the electric heater. Meanwhile, since the power module of this embodiment integrates the power chips for controlling the electric motor and the power chips for controlling the electric heater, heat dissipation for the multiple power chips can be achieved only by installing the power module on a heat sink. There is no need to install the power chips on the heat sink one by one for heat dissipation, which not only improves the installation efficiency of the power module but also enhances the heat dissipation efficiency.

In some embodiments, the power chips of the electric motor control section include at least one of an IGBT chip, a SiC chip, a MOSFET chip, and a GaN chip. In other words, the integrated power chips of the power module in this embodiment are not limited to IGBTs, and may also be integrated with SiC (Silicon Carbide), MOSFET (Metal-Oxide-Semiconductor Field-Effect Transistor), GaN (Gallium Nitride), etc.

In some embodiments, the plurality of power chips of the electric heater control section include at least one of an IGBT chip, a SiC chip, a MOSFET chip, and a GaN chip.

In some embodiments, the power module further includes a plurality of temperature sensors, which are built into the power module and configured to detect the temperatures of the plurality of power chips of the electric motor control section and the plurality of power chips of the electric heater control section.

In this way, by incorporating built-in temperature sensors in the power module, accurate detection of the temperatures of the power chips within the power module is achieved, reducing the risk of thermal failure of the power chips.

It can be understood that packaging technologies such as reflow soldering and aluminum wire ultrasonic bonding can be used to package the temperature sensors with the plurality of power chips in the power module.

In some embodiments, the power module further includes a direct bonded copper ceramic substrate, and the plurality of power chips of the electric motor control section and the plurality of power chips of the electric heater control section are mounted on the direct bonded copper ceramic substrate.

In this way, the plurality of power chips of the electric motor control section and the plurality of power chips of the electric heater control section are mounted on the direct bonded copper ceramic substrate. The power chips in the direct bonded copper ceramic substrate are insulated from a heat dissipation surface of the direct bonded copper ceramic substrate. When in use, the power module can be directly mounted on a heatsink board for use without adding any thermal conductive insulating cloth or ceramic sheets outside the power module to achieve insulation and thermal conductivity. This avoids the increase in module thermal resistance caused by adding thermal conductive insulating cloth or ceramic sheets, which is beneficial to improving the thermal conductivity efficiency of each power chip and reducing the risk of thermal failure of each power chip.

In some embodiments, the plurality of power chips of the electric motor control section include a first chip unit, a second chip unit, a third chip unit, a fourth chip unit, a fifth chip unit, and a sixth chip unit.

The plurality of power chips of the electric heater control section include a seventh chip unit, an eighth chip unit, and a ninth chip unit.

In some embodiments, each power chip includes a first port, a second port, and a third port, where the first port is a gate, the second port is a collector, and the third port is an emitter.

In some embodiments, the power module includes at least 32 pins, which are sequentially a first pin to a thirty-second pin.

The first port of the first chip unit is connected to the first pin of the power module, and the second port of the first chip unit is connected to the second port of the second chip unit, the second port of the third chip unit, the second port of the seventh chip unit, and the eighteenth pin of the power module. The third port of the first chip unit is connected to the second pin of the power module, the second port of the fourth chip unit, and the nineteenth pin of the power module.

The first port of the second chip unit is connected to the third pin of the power module. The third port of the second chip unit is connected to the fourth pin of the power module, the second port of the fifth chip unit, and the twentieth pin of the power module. The first port of the third chip unit is connected to the fifth pin of the power module.

The third port of the third chip unit is connected to the sixth pin of the power module, the second port of the sixth chip unit, and the twenty-first pin of the power module.

The first port of the fourth chip unit is connected to the seventh pin of the power module. The third port of the fourth chip unit is connected to the eighth pin of the power module and the twenty-second pin of the power module. The first port of the fifth chip unit is connected to the ninth pin of the power module.

The third port of the fifth chip unit is connected to the tenth pin of the power module and the twenty-third pin of the power module. The first port of the sixth chip unit is connected to the eleventh pin of the power module.

The third port of the sixth chip unit is connected to the twelfth pin of the power module and the twenty-fourth pin of the power module. The first port of the seventh chip unit is connected to the thirteenth pin of the power module.

The emitter of the seventh chip unit is connected to the fourteenth pin of the power module and the twenty-fifth pin of the power module. The first port of the eighth chip unit is connected to the fifteenth pin of the power module. The second port of the eighth chip unit is connected to the twenty-sixth pin of the power module.

The third port of the eighth chip unit is connected to the third port of the ninth chip unit, the seventeenth pin of the power module and the twenty-eighth pin of the power module.

The first port of the ninth chip unit is connected to the sixteenth pin of the power module.

The second port of the ninth chip unit is connected to the twenty-seventh pin of the power module.

In some embodiments, the first chip unit, the second chip unit, the third chip unit, the fourth chip unit, the fifth chip unit, and the sixth chip unit each include IGBT chips. The seventh chip unit, the eighth chip unit, and the ninth chip unit are all IGBT chips.

In some embodiments, the first chip unit is a first IGBT chip. The second chip unit is a second IGBT chip. The third chip unit is a third IGBT chip. The fourth chip unit is a fourth IGBT chip. The fifth chip unit is a fifth IGBT chip. The sixth chip unit is a sixth IGBT chip. As shown in FIG. 1, 1 denotes the first IGBT chip, 2 denotes the second IGBT chip, 3 denotes the third IGBT chip, 4 denotes the fourth IGBT chip, 5 denotes the fifth IGBT chip, and 6 denotes the sixth IGBT chip, which are 6 IGBT chips forming a three-phase full-bridge to control the electric motor. 7 denotes the seventh IGBT chip, 8 denotes the eighth IGBT chip, and 9 denotes the ninth IGBT chip, which are three IGBT chips configured to control the electric heater.

In other embodiments, the first chip unit includes a first IGBT chip and a first FRD chip connected in anti-parallel. The second chip unit includes a second IGBT chip and a second FRD chip connected in anti-parallel. The third chip unit includes a third IGBT chip and a third FRD chip connected in anti-parallel. The fourth chip unit includes a fourth IGBT chip and a fourth FRD chip connected in anti-parallel. The fifth chip unit includes a fifth IGBT chip and a fifth FRD chip connected in anti-parallel. The sixth chip unit includes a sixth IGBT chip and a sixth FRD chip connected in anti-parallel. The seventh chip unit is a seventh IGBT chip. The eighth chip unit is an eighth IGBT chip. The ninth chip unit is a ninth IGBT chip. As shown in FIG. 2, 1 denotes the first chip unit, 2 denotes the second chip unit, 3 denotes the third chip unit, 4 denotes the fourth chip unit, 5 denotes the fifth chip unit, and 6 denotes the sixth chip unit, which form a three-phase full-bridge to control the electric motor. 7 denotes the seventh chip unit, 8 denotes the eighth chip unit, and 9 denotes the ninth chip unit, which are three IGBT chips configured to control the electric heater.

As shown in FIG. 1 and FIG. 2, the gate of the first IGBT chip is connected to the first pin of the power module. The collector of the first IGBT chip is connected to the collector of the second IGBT chip, the collector of the third IGBT chip, the collector of the seventh IGBT chip, and the eighteenth pin of the power module. The emitter of the first IGBT chip is connected to the second pin of the power module, the collector of the fourth IGBT chip, and the nineteenth pin of the power module. The gate of the second IGBT chip is connected to the third pin of the power module. The emitter of the second IGBT chip is connected to the fourth pin of the power module, the collector of the fifth IGBT chip, and the twentieth pin of the power module. The gate of the third IGBT chip is connected to the fifth pin of the power module. The emitter of the third IGBT chip is connected to the sixth pin of the power module, the collector of the sixth IGBT chip, and the twenty-first pin of the power module. The gate of the fourth IGBT chip is connected to the seventh pin of the power module. The emitter of the fourth IGBT chip is connected to the eighth pin of the power module and the twenty-second pin of the power module. The gate of the fifth IGBT chip is connected to the ninth pin of the power module. The emitter of the fifth IGBT chip is connected to the tenth pin of the power module and the twenty-third pin of the power module. The gate of the sixth IGBT chip is connected to the eleventh pin of the power module. The emitter of the sixth IGBT chip is connected to the twelfth pin of the power module and the twenty-fourth pin of the power module. The gate of the seventh IGBT chip is connected to the thirteenth pin of the power module. The emitter of the seventh IGBT chip is connected to the fourteenth pin of the power module and the twenty-fifth pin of the power module. The gate of the eighth IGBT chip is connected to the fifteenth pin of the power module. The collector of the eighth IGBT chip is connected to the twenty-sixth pin of the power module. The emitter of the eighth IGBT chip is connected to the emitter of the ninth IGBT chip, the seventeenth pin, and the twenty-eighth pin of the power module. The gate of the ninth IGBT chip is connected to the sixteenth pin of the power module. The collector of the ninth IGBT chip is connected to the twenty-seventh pin of the power module.

In some embodiments, the first pin is the GUH pin. The second pin is the KUN pin. The third pin is the GVH pin. The fourth pin is the KVH pin. The fifth pin is the GWH pin. The sixth pin is the KWH pin. The seventh pin is the GUL pin. The eighth pin is the KUL pin. The ninth pin is the GVL pin. The tenth pin is the KVL pin. The eleventh pin is the GWL pin. The twelfth pin is the KWL pin. The thirteenth pin is the G1 pin. The fourteenth pin is the K1 pin. The fifteenth pin is the G2 pin. The sixteenth pin is the G3 pin. The seventeenth pin is the K23 pin. The eighteenth pin is the P pin. The nineteenth pin is the U pin. The twentieth pin is the V pin. The twenty-first pin is the W pin. The twenty-second pin is the NU pin. The twenty-third pin is the NV pin. The twenty-fourth pin is the NW pin. The twenty-fifth pin is the E1 pin. The twenty-sixth pin is the C2 pin. The twenty-seventh pin is the C3 pin. The twenty-eighth pin is the E23 pin.

In some embodiments, the plurality of built-in temperature sensors of the power module include a first temperature sensor and a second temperature sensor. One end of the first temperature sensor is connected to twenty-ninth pin of the power module, and the other end of the first temperature sensor is connected to the thirtieth pin of the power module. One end of the second temperature sensor is connected to the thirty-first pin of the power module, and the other end of the second temperature sensor is connected to the thirty-second pin of the power module. The twenty-ninth pin is the T1-1 pin, the thirtieth pin is the T1-2 pin, the thirty-first pin is the T2-1 pin, and the thirty-second pin is the T2-2 pin.

As shown in FIG. 1, 10 denotes the first temperature sensor and 11 denotes the second temperature sensor. Both the first temperature sensor 10 and the second temperature sensor 11 are built-in temperature sensors of the power module, which are configured to detect the temperatures of the power chips in the power module.

According to an exemplary embodiment, it provides a manufacturing method for a power module. A plurality of power chips for driving an electric motor and a plurality of power chips for driving an electric heater are integrated onto a direct bonded copper ceramic substrate by a process including reflow soldering and aluminum wire ultrasonic bonding to jointly form the power module. The plurality of power chips for driving the electric motor form the electric motor control section of the power module, and the plurality of power chips for driving the electric heater form the electric heater control section of the power module.

In some embodiments, a plurality of temperature sensors and power chips are packaged in the power module by a process including reflow soldering and aluminum wire ultrasonic bonding.

The power module and its manufacturing method according to the present disclosure are applied in fields such as power electronics, electric motor drives, power semiconductors, and semiconductor packaging. The power module of the present disclosure overcomes the problem that the power module for controlling the electric motor and the power module for controlling the heater in the integrated controller product of the vehicle electric compressor and electric heater are relatively independent. Through power semiconductor module packaging technology, the power module of the present disclosure can encapsulate and integrate a plurality of IGBT chips into one module using processes such as reflow soldering and aluminum wire ultrasonic bonding. The power module has a small volume, which can further reduce the volume of the controller. The power module of the present disclosure uses DBC (Direct Bonded Copper) for heat dissipation, which increases the thermal conductivity of the IGBT and reduces the risk of thermal failure of the IGBT. The installation process of the power module of the present disclosure is simple, which is conducive to simplifying the production process of the controller and improving production reliability. The power module of the present disclosure has a built-in temperature sensor, which makes temperature detection more accurate and helps reduce the risk of thermal failure of the IGBT.

In this description, the same and similar parts among the various embodiments can be referred to each other, and each embodiment focuses on explaining the differences from other embodiments. In particular, for the embodiments described later, the description is relatively simple, and the relevant parts can be referred to the descriptions in the foregoing embodiments.

The technical features of the above-mentioned embodiments can be combined arbitrarily. To make the description concise, not all possible combinations of the various technical features in the above-mentioned embodiments have been described. However, as long as there is no contradiction in the combination of these technical features, they should be regarded as being within the scope recorded in this description.

The above-mentioned embodiments only express several implementation modes of the present disclosure, and their descriptions are relatively specific and detailed, but they should not be understood as limiting the scope of the patent application. It should be pointed out that for those of ordinary skill in the art, without departing from the concept of the present disclosure, several modifications and improvements can also be made, which all belong to the protection scope of the present disclosure. Therefore, the protection scope of the patent of the present disclosure shall be subject to the appended claims.

## Claims

1. A power module, **characterized by** comprising:
an electric motor control section, comprising a plurality of power chips for driving an electric motor; and
an electric heater control section, comprising a plurality of power chips for driving an electric heater,
wherein the plurality of power chips of the electric motor control section and the plurality of power chips of the electric heater control section are integrated in the power module.

2. The power module according to claim 1, wherein the power chips of the electric motor control section comprise at least one of an IGBT chip, a SiC chip, a MOSFET chip, and a GaN chip.

3. The power module according to claim 1, wherein the plurality of power chips of the electric heater control section comprise at least one of an IGBT chip, a SiC chip, a MOSFET chip, and a GaN chip.

4. The power module according to claim 1, wherein the plurality of power chips of the electric motor control section comprise a first chip unit, a second chip unit, a third chip unit, a fourth chip unit, a fifth chip unit, and a sixth chip unit.

5. The power module according to claim 4, wherein each of the first chip unit, the second chip unit, the third chip unit, the fourth chip unit, the fifth chip unit, and the sixth chip unit comprises an IGBT chip.

6. The power module according to claim 4, wherein the plurality of power chips of the electric heater control section comprise a seventh chip unit, an eighth chip unit, and a ninth chip unit.

7. The power module according to claim 6, wherein the seventh chip unit, the eighth chip unit, and the ninth chip unit are all IGBT chips.

8. The power module according to claim 6, wherein each of the power chips comprises a first port, a second port, and a third port, the first port is a gate, the second port is a collector, and the third port is an emitter.

9. The power module according to claim 8, wherein
the first port of the first chip unit is connected to a first pin of the power module;
the second port of the first chip unit is connected to the second port of the second chip unit, the second port of the third chip unit, the second port of the seventh chip unit, and an eighteenth pin of the power module;
the third port of the first chip unit is connected to a second pin of the power module, the second port of the fourth chip unit, and a nineteenth pin of the power module;
the first port of the second chip unit is connected to a third pin of the power module;
the third port of the second chip unit is connected to a fourth pin of the power module, the second port of the fifth chip unit, and a twentieth pin of the power module;
the first port of the third chip unit is connected to a fifth pin of the power module;
the third port of the third chip unit is connected to a sixth pin of the power module, the second port of the sixth chip unit, and a twenty-first pin of the power module;
the first port of the fourth chip unit is connected to a seventh pin of the power module;
the third port of the fourth chip unit is connected to an eighth pin of the power module and a twenty-second pin of the power module;
the first port of the fifth chip unit is connected to a ninth pin of the power module;
the third port of the fifth chip unit is connected to a tenth pin of the power module and a twenty-third pin of the power module;
the first port of the sixth chip unit is connected to an eleventh pin of the power module; and
the third port of the sixth chip unit is connected to a twelfth pin of the power module and a twenty-fourth pin of the power module.

10. The power module according to claim 9, wherein the first pin is a GUH pin, the second pin is a KUN pin, the third pin is a GVH pin, the fourth pin is a KVH pin, the fifth pin is a GWH pin, the sixth pin is a KWH pin, the seventh pin is a GUL pin, the eighth pin is a KUL pin, the ninth pin is a GVL pin, the tenth pin is a KVL pin, the eleventh pin is a GWL pin, the twelfth pin is a KWL pin, the eighteenth pin is a P pin, the nineteenth pin is a U pin, the twentieth pin is a V pin, the twenty-first pin is a W pin, the twenty-second pin is a NU pin, the twenty-third pin is a NV pin, and the twenty-fourth pin is a NW pin.

11. The power module according to claim 10, wherein
the first port of the seventh chip unit is connected to a thirteenth pin of the power module;
the emitter of the seventh chip unit is connected to a fourteenth pin of the power module and a twenty-fifth pin of the power module;
the first port of the eighth chip unit is connected to a fifteenth pin of the power module;
the second port of the eighth chip unit is connected to a twenty-sixth pin of the power module;
the third port of the eighth chip unit is connected to the third port of the ninth chip unit, a seventeenth pin of the power module and a twenty-eighth pin of the power module;
the first port of the ninth chip unit is connected to a sixteenth pin of the power module; and
the second port of the ninth chip unit is connected to a twenty-seventh pin of the power module.

12. The power module according to claim 11, wherein the thirteenth pin is a G1 pin, the fourteenth pin is a K1 pin, the fifteenth pin is a G2 pin, the sixteenth pin is a G3 pin, the seventeenth pin is a K23 pin, the twenty-fifth pin is a E1 pin, the twenty-sixth pin is a C2 pin, the twenty-seventh pin is a C3 pin, and the twenty-eighth pin is a E23 pin.

13. The power module according to any one of claims 1-12, wherein the power module further comprises:
a direct bonded copper ceramic substrate, on which the plurality of power chips of the electric motor control section and the plurality of power chips of the electric heater control section are mounted.

14. The power module according to any one of claims 1-12, wherein the power module further comprises:
a plurality of temperature sensors configured to detect temperatures of the plurality of power chips of the electric motor control section and temperatures of the plurality of power chips of the electric heater control section.

15. The power module according to claim 14, wherein the plurality of temperature sensors comprise a first temperature sensor and a second temperature sensor;
one end of the first temperature sensor is connected to a twenty-ninth pin of the power module;
the other end of the first temperature sensor is connected to a thirtieth pin of the power module;
one end of the second temperature sensor is connected to a thirty-first pin of the power module;
the other end of the second temperature sensor is connected to a thirty-second pin of the power module; and
the twenty-ninth pin is a T1-1 pin, the thirtieth pin is a T1-2 pin, the thirty-first pin is a T2-1 pin, and the thirty-second pin is a T2-2 pin.

16. A manufacturing method for a power module, **characterized by** comprising integrating, by a process comprising reflow soldering and aluminum wire ultrasonic bonding, a plurality of power chips for driving an electric motor and a plurality of power chips for driving an electric heater onto a direct bonded copper ceramic substrate to jointly form the power module.

17. The manufacturing method for the power module according to claim 16, **characterized by** comprising packaging, by a process comprising reflow soldering and aluminum wire ultrasonic bonding, a plurality of temperature sensors, the plurality of power chips for driving the electric motor, and the plurality of power chips for driving the electric heater in the power module.
